# EUROPÄISCHE PATENTSCHRIFT

(11) **EP 3 966 872 B1**
(45) Veröffentlichungstag und Bekanntmachung des Hinweises auf die Patenterteilung: **19.07.2023**
(21) Anmeldenummer: 19722888.5
(22) Anmeldetag: 07.05.2019
(51) Int. Cl.: H01L 31/054, H01L 31/049, H01L 31/044, H02S 20/23

(54) **KONZENTRATOR-PHOTOVOLTAIK-MODUL**
CONCENTRATOR PHOTOVOLTAIC MODULE
MODULE PHOTOVOLTAÏQUE DE CONCENTRATEUR

(43) Veröffentlichungstag der Anmeldung: 16.03.2022
(73) Patentinhaber: FOXLED1 AG, 6331 Hünenberg (CH)
(72) Erfinder: SCHIBLI, Peter, 6331 Hünenberg (CH)
(74) Vertreter: E. Blum & Co. AG
(86) Internationale Anmeldenummer: PCT/EP2019/061745
(87) Internationale Veröffentlichungsnummer: WO 2020/224770

(56) Entgegenhaltungen:
- EP-A1- 2 999 003
- WO-A1-2006/123194
- WO-A2-2009/023063
- US-A1- 2009 183 764

## Beschreibung

### Gebiet der Erfindung

Die Erfindung betrifft ein Konzentrator-Photovoltaik-Modul mit einem Photovoltaik-Chip. Die Erfindung betrifft ausserdem ein photovoltaisches System mit einer Vielzahl von Konzentrator-Photovoltaik-Modulen. Ferner betrifft die Erfindung ein Verfahren zur Herstellung eines photovoltaischen Systems.

### Hintergrund

Photovoltaik ist die Umwandlung von Lichtenergie, meist aus Sonnenlicht, in elektrische Energie mittels Solarzellen bzw. Photovoltaikzellen.

Die Konzentrator-Photovoltaik verwendet Linsen und/oder Reflektoren, um das Sonnenlicht auf Photovoltaikzellen zu konzentrieren. Dies ermöglicht eine Verringerung der Zellgröße. Die Energieumwandlung wird in der Regel von einer speziellen Hochleistungs-Solarzelle durchgeführt, insbesondere mittels hocheffizienten Mehrfach (Multi-Junction) Solarzellen aus beispielsweise III-V Halbleitermaterialien.

Konzentrator-Photovoltaik Systeme werden nach der Menge ihrer Sonnenkonzentration kategorisiert, gemessen in "Sonnen". Dabei unterscheidet man niedrigkonzentrierte Systeme, Systeme mit mittlerer Konzentration und hochkonzentrierte Systeme.

Eine steigende Konzentration erhöht in der Regel auch die Komplexität des Systems. Insbesondere steigen die Anforderungen an die Kühlung und die Optik.

Niedrigkonzentrierte Systeme verfügen oft über einen einfachen Booster-Reflektor, der die solare elektrische Leistung aber teilweise bereits um mehr als 30% gegenüber Nicht-Konzentrator-Systemen erhöhen kann.

Hochkonzentrierte Systeme dagegen verwenden komplexere optische Systeme. Diese können z.B. aus einer Fresnel-Linse als primäre Optik und einem Reflektor als sekundäre Optik bestehen.

Die WO2009023063 A2 offenbart einen Sonnenenergieempfänger, der eine Absorptionsöffnung umfasst, welche derart ausgestaltet ist, dass Sonnenstrahlung aus einer bestimmten Richtung bevorzugt von einem Sonnenstrahlungsabsorber in dem Empfänger absorbiert werden kann. Die Empfänger können in linearen Fresnel-Reflektor-Solaranordnungen verwendet werden.

EP 2999003 A1 zeigt ein Solarzellenmodul, ein Solarzellenpanel und einen Konzentrator. Das Solarzellenpanel enthält eine Solarzelle. Der Konzentrator hat eine erste Oberfläche und eine zweite Oberfläche. Die erste Oberfläche reflektiert unter einem ersten Einfallswinkel einfallendes Licht und strahlt das unter dem ersten Einfallswinkel einfallende Licht auf einen ersten Abschnitt innerhalb des Bereichs der Solarzelle. Die zweite Oberfläche reflektiert unter einem zweiten Einfallswinkel einfallendes Licht und strahlt das unter dem zweiten Einfallswinkel einfallende Licht auf einen zweiten Abschnitt innerhalb des Bereichs der Solarzelle.

US 2009183764 A1 zeigt ein abnehmbares Lamellensystem, das primäre Lamellen und einen Rahmen umfasst. Die primären Lamellen sind im Wesentlichen parallel zueinander angeordnet und dazu konfiguriert, auf die primären Lamellen einfallende Lichtstrahlen auf photovoltaische Bereiche eines photovoltaischen Moduls zu reflektieren. Der Rahmen ist so konfiguriert, dass er die primären Lamellen trägt und das abnehmbare Lamellensystem lösbar mit dem Photovoltaikmodul koppelt.

WO 2006123194 A1 zeigt ein stationäres Photovoltaikmodul, das aus parabolischen Konzentrationsspiegeln und aktiven Photovoltaiksegmenten aus kristallinem Silizium oder Submodulen aus dünnschichtigen photovoltaischen Halbleitermaterialien besteht. Die aktiven Photovoltaiksegmente sind elektrisch miteinander verbunden, und die maximale Höhe der symmetrischen oder asymmetrischen Metallspiegel, die durch eine optisch transparente Beschichtung geschützt sind, entspricht ungefähr der Breite eines einzelnen Photovoltaiksegments.

### Darstellung der Erfindung

Es ist eine Aufgabe von Ausführungsformen der vorliegenden Erfindung, ein Konzentrator-Photovoltaik-Modul zu schaffen, welches Nachteile des Bekannten vermeidet.

Eine weitere Aufgabe von Ausführungsformen der vorliegenden Erfindung besteht darin, ein Konzentrator-Photovoltaik-Modul zu schaffen, welches eine bessere Ausnutzung der Sonnenenergie ermöglicht, und dies insbesondere in kostengünstiger und effizienter Weise.

Ein erster Aspekt der Erfindung betrifft ein Konzentrator-Photovoltaik-Modul gemäss Anspruch 1.

Demgemäss weist das Konzentrator-Photovoltaik-Modul ein Gehäuse, einen Photovoltaik-Chip, wenigstens zwei elektrische Kontakte zur Kontaktierung des Photovoltaik-Chips und eine transparente Abdeckung auf. Das Gehäuse weist einen Basiskörper aus Kunststoff und der Basiskörper weist eine Aussparung auf, welche eine Aufnahmewanne mit einem vertieften Bodenabschnitt zur Aufnahme des Photovoltaik-Chips bildet. Die Aufnahmewanne weist Seitenwände mit wenigstens einem ersten und einem zweiten reflektierendem Bereich auf. Der erste reflektierende Bereich ist in einem ersten Winkel gegenüber einer horizontalen Ebene des Gehäuses ausgerichtet und der zweite reflektierende Bereich ist in einem zweiten Winkel gegenüber der horizontalen Ebene des Gehäuses ausgerichtet. Der erste Winkel ist unterschiedlich zu dem zweiten Winkel.

Ein derart ausgestaltetes Konzentrator-Photovoltaik-Modul ermöglicht es, die beiden unterschiedlichen Winkel des ersten reflektierenden Bereichs und des zweiten reflektierenden Bereichs individuell zu wählen und an die jeweiligen äusseren Gegebenheiten, insbesondere die jeweilige Ausrichtung der zum Einbau vorgesehenen Flächen und die jeweilige Sonnenexposition der zum Einbau vorgesehenen Flächen zu berücksichtigen. Der erste und der zweite reflektierende Bereich bilden reflektierende Flächen, welche das Sonnenlicht über die transparente Glasabdeckung empfangen, reflektieren und in Richtung des Photovoltaik-Chips weiterleiten bzw. es auf den Photovoltaik-Chip konzentrieren. Somit bilden die wenigstens zwei reflektierenden Bereiche der Aufnahmewanne einen Reflektor.

Es ist hierbei zu beachten, dass der Begriff horizontale Ebene des Gehäuses sich auf die Grundfläche bzw. Bodenfläche des Gehäuses bezieht und insbesondere parallel zu der Bodenfläche des Gehäuses verlaufen soll. Der Begriff horizontale Ebene des Gehäuses soll sich somit nicht notwendigerweise auf die jeweilige Einbausituation des Gehäuses beziehen. So kann z.B. bei einem senkrechten Einbau des Gehäuses an einer Hauswand die horizontale Ebene des Gehäuses senkrecht zu dem Boden des Hauses verlaufen.

Das Modul ist als oberflächenmontierbares Modul ausgebildet. Dies hat insbesondere fertigungstechnische Vorteile. Derartige oberflächenmontierbare Module, welche auch als SMD-Module (Surface Mounted Device) bezeichnet werden, können in besonders effizienter und automatisierter Weise montiert und verarbeitet werden.

Das Gehäuse mit dem Basiskörper aus Kunststoff kann beispielsweise mittels eines Spritzgussverfahrens in einfacher und effizienter Weise hergestellt werden.

Die transparente Abdeckung besteht vorzugsweise aus Glas, insbesondere aus Gorilla^{®}-Glas. Die transparente bzw. lichtdurchlässige Abdeckung lässt gemäss bevorzugten Ausführungsformen das Sonnenlicht möglichst ungehindert in den Reflektor der Aufnahmewanne passieren und ist daher gemäss Ausführungsformen als plane Fläche ausgebildet. Im Querschnitt ist die transparente Abdeckung insbesondere rechteckig, wobei die Dicke der Abdeckung möglichst klein gewählt ist, beispielsweise 0.4 mm bis 1 mm.

Gemäss weiteren Ausführungsformen kann die transparente Abdeckung aber auch eine konkave oder konvexe Form aufweisen und das Sonnenlicht somit umlenken und/oder fokussieren.

Der Photovoltaik-Chip kann gemäss Ausführungsformen als Einfach- oder als Mehrfachsolarzelle ausgebildet sein, insbesondere als 3-fach Solarzelle ("triple-junction")oder Vierfach-Solarzelle ("quadrupel-junction"). Gemäss besonders bevorzugten Ausführungsformen ist der Photovoltaik-Chip eine Mehrfachsolarzelle aus einem III-V Halbleitermaterial, z.B. aus Galliumarsenid (GaAs) oder Galliumantimonid (GaSb). Der Photovoltaik-Chip ist insbesondere als ein photovoltaischer DIE, d.h. ein ungehäustes Stück eines Halbleiter-Wafers, ausgeführt.

Durch die unterschiedlichen Winkel des ersten reflektierenden Bereichs und des zweiten reflektierenden Bereichs kann die Konzentrations- bzw. Reflexionswirkung und der Wirkungsgrad des Konzentrator-Photovoltaik-Moduls in einfacher, kostengünstiger und effizienter Weise erhöht werden.

Gemäss einer Ausführungsform der Erfindung ist der Photovoltaik-Chip in Bezug auf wenigstens eine vertikale Symmetrieebene des Gehäuses asymmetrisch angeordnet. Mittels einer derartigen asymmetrischen Anordnung des Photovoltaik-Chips in dem Gehäuse lassen sich die unterschiedlichen Winkel des ersten und des zweiten reflektierenden Bereichs besonders effizient und platzsparend in dem Gehäuse realisieren.

Gemäss einer weiteren Ausführungsform der Erfindung liegen sich der erste und der zweite reflektierende Bereich in Bezug auf eine erste vertikale Symmetrieebene des Photovoltaik-Chips gegenüber. Mit anderen Worten, der erste und der zweite reflektierende Bereich sind an gegenüberliegenden Seiten des Photovoltaik-Chips angeordnet.

Eine derartige Ausführungsform mit sich gegenüberliegenden reflektierenden Flächen mit unterschiedlichen Winkeln ermöglicht eine verbesserte Konzentration des Sonnenlichts auf den Photovoltaik-Chip, insbesondere bei Sonnenlicht, welches nicht parallel zu der ersten vertikalen Symmetrieebene des Photovoltaik-Chips einfällt.

Gemäss einer Ausführungsform der Erfindung unterscheiden sich der erste Winkel und der zweite Winkel um wenigstens 10°, insbesondere um wenigstens 20° voneinander.

Derartig ausgebildete unterschiedliche Winkel sind insbesondere dann vorteilhaft, wenn die Sonneneinstrahlung nicht senkrecht bzw. symmetrisch in Bezug auf die Senkrechte auf das Konzentrator-Photovoltaik-Modul fällt. Bei derartigen Gegebenheiten ermöglichen derart unterschiedliche Winkel eine verbesserte optische Konzentrationswirkung der reflektierenden Bereiche bzw. der reflektierenden Flächen.

Gemäss einer Ausführungsform der Erfindung sind die wenigstens zwei elektrischen Kontakte an wenigstens zwei Seiten des Gehäuses angeordnet.

Gemäss einer Ausführungsform der Erfindung ist sind die wenigstens zwei elektrischen Kontakte unter dem Gehäuse angeordnet.

Gemäss einer Ausführungsform der Erfindung sind der erste reflektierende Bereich und der zweite reflektierende Bereich als reflektierende Beschichtung der Aufnahmewanne ausgebildet. Eine derartige Beschichtung kann gemäss Ausführungsformen z.B. mittels eines entsprechenden Beschichtungsverfahrens auf dem Basiskörper aus Kunststoff aufgebracht werden.

Gemäss einer weiteren Ausführungsform der Erfindung sind der erste reflektierende Bereich und der zweite reflektierende Bereich als reflektierende Folie ausgebildet.

Eine derartige reflektierende Folie, z.B. eine Metallfolie, kann gemäss Ausführungsformen z.B. mittels eines entsprechenden Klebeverfahrens auf dem Basiskörper aus Kunststoff aufgebracht werden.

Gemäss einer anderen Ausführungsform der Erfindung sind der erste reflektierende Bereich und der zweite reflektierende Bereich als separater Einsatz ausgebildet. Der separate Einsatz ist in die Aufnahmewanne des Gehäuses eingesetzt.

Bei dieser Ausführungsform bilden der erste reflektierende Bereich und der zweite reflektierende Bereich einen separaten Reflektor, der in die Aussparung eingesetzt wird. Der separate Reflektor kann vorgefertigt werden und dann in den Basiskörper des Gehäuses eingesetzt und daran befestigt werden. Dies ermöglicht eine grosse Flexibilität in der Fertigung. So ist es beispielsweise möglich, den Basiskörper aus Kunststoff in grossen Stückzahlen mittels Spritzgiessen zu fertigen. Parallel dazu können die Einsätze aus Kunststoff oder Metall gefertigt werden. Dabei ist es möglich, Einsätze mit verschiedenen Winkelkombinationen vorzufertigen. Diese vorgefertigten Einsätze können dann in einem nächsten Schritt in die Aussparungen der Basiskörper eingesetzt und daran befestigt werden, z.B. mittels Ultraschallschweissen. Dadurch ist es möglich, in die gleichen Basiskörper Reflektoren mit unterschiedlichen Winkelkombinationen einzubauen.

Gemäss weiteren Ausführungsformen der Erfindung weist die Aufnahmewanne Seitenwände mit einem dritten und einem vierten reflektierenden Bereich auf. Der dritte reflektierende Bereich ist in einem dritten Winkel gegenüber der horizontalen Ebene des Gehäuses ausgerichtet und der vierte reflektierende Bereich ist in einem vierten Winkel gegenüber der horizontalen Ebene des Gehäuses ausgerichtet. Gemäss weiteren Ausführungsformen ist der dritte Winkel unterschiedlich zu dem vierten Winkel.

Derartige Ausführungsformen weisen somit vier unterschiedliche Reflexionsbereiche bzw. Reflexionsflächen auf, welche jeweils mit individuellen und unterschiedlichen Winkeln gegenüber der horizontalen Ebene des Gehäuses ausgerichtet sein können.

Die vier Reflexionsbereiche bilden einen Reflektor. Durch die bis zu vier unterschiedlichen Winkel des Reflektors wird eine weitere Verbesserung der Konzentrationswirkung bzw. Reflexionswirkung des Reflektors ermöglicht. Insbesondere kann gemäss Ausführungsformen der Erfindung der Reflektor sowohl in Bezug auf die Elevation als auch in Bezug auf den Azimut der Sonneneinstrahlung optimiert und werden. Dadurch kann die Reflektor-Wirkung für den jeweiligen Standort optimiert werden.

Dabei sind zwei der vier Winkel, z.B. der erste Winkel und der zweite Winkel, gemäss Ausführungsformen der Erfindung insbesondere so gewählt, dass sie die jeweilige Einbausituation des Moduls optimal in Bezug auf die Elevation der Sonne berücksichtigen.

Ferner sind zwei der vier Winkel, z.B. der dritte Winkel und der vierte Winkel gemäss Ausführungsformen der Erfindung so gewählt, dass sie die jeweilige Einbausituation des Moduls optimal in Bezug auf den Azimut der Sonne berücksichtigen. Somit lassen sich gemäss Ausführungsformen der Erfindung Konzentrator-Photovoltaik-Module fertigen, bei denen die jeweiligen Winkelausrichtungen des Reflektors optimal an die vorgesehene Einbausituation des Moduls angepasst sind.

Dementsprechend können Module gemäss Ausführungsformen der Erfindung sowohl für senkrechte Hauswände, für Schrägdächer als auch für Flachdächer mit jeweils optimierten Winkelkombinationen gefertigt werden.

Gemäss einer Ausführungsform sind der dritte Winkel und der vierte Winkel um wenigstens 10°, insbesondere um wenigstens 20° unterschiedlich.

Derartig ausgebildete unterschiedliche Winkel sind insbesondere dann vorteilhaft, wenn die Sonneneinstrahlung nicht senkrecht bzw. symmetrisch in Bezug auf eine senkrechte Symmetrieebene des Konzentrator-Photovoltaik-Moduls fällt. Bei derartigen Gegebenheiten ermöglichen derart unterschiedliche Winkel eine verbesserte optische Konzentrationswirkung der reflektierenden Bereiche bzw. der reflektierenden Flächen.

Gemäss Ausführungsformen der Erfindung liegen der erste Winkel, der zweite Winkel, der dritte Winkel und der vierte Winkel in einem Bereich zwischen 0° und 90°.

Gemäss Ausführungsformen kann der erste Winkel in einem Bereich zwischen 45° und 90°, insbesondere in einem Bereich zwischen 60° und 75° und der zweite Winkel in einem Bereich zwischen 0° und 45°, insbesondere in einem Bereich zwischen 10° und 35°, liegen. Derartige Winkel können insbesondere für senkrechte Einbausituationen vorteilhaft sein.

Gemäss weiteren Ausführungsformen kann der dritte Winkel in einem Bereich zwischen 0° und 45° liegen, insbesondere in einem Bereich zwischen 10° und 35 und der vierte Winkel in einem Bereich zwischen 30° und 90° liegt, insbesondere in einem Bereich zwischen 45° und 75°. Derartige Winkel können insbesondere für die Anpassung an den azimutalen Sonnenverlauf vorteilhaft sein.

Gemäss Ausführungsformen der Erfindung liegen sich der erste und der zweite reflektierende Bereich in Bezug auf eine erste vertikale Symmetrieebene des Photovoltaik-Chips gegenüber und der dritte und der vierte reflektierende Bereich liegen sich in Bezug auf eine zweite vertikale Symmetrieebene des Photovoltaik-Chips gegenüber. Dabei verlaufen die erste vertikale Symmetrieebene und die zweite vertikale Symmetrieebene insbesondere senkrecht zueinander.

Gemäss Ausführungsformen der Erfindung ist das Modul gegen feste Fremdkörper und gegen Flüssigkeiten geschützt. Gemäss Ausführungsformen weist das Modul einen Schutzumfang gemäss dem International Protection (IP-Code) gegen feste Fremdkörper von wenigstens 5 und einen Schutzumfang gegen Flüssigkeiten von wenigstens 5 auf. Ein derart geschütztes Modul gewährleistet einen zuverlässigen und langlebigen Betrieb auch bei widrigen Umweltbedingungen. Dabei kann das Modul insbesondere gemäss den IP Schutzklassen 65 bis 68 geschützt sein.

Gemäss Ausführungsformen der Erfindung sind der erste reflektierende Bereich, der zweite reflektierende Bereich, der dritte reflektierende Bereich und/oder der vierte reflektierende Bereich jeweils als konkave Fläche ausgebildet.

Mittels derartiger konkaver Flächen kann die Konzentrationswirkung der reflektierenden Bereiche erhöht werden.

Gemäss anderen Ausführungsformen der Erfindung sind der erste reflektierende Bereich, der zweite reflektierende Bereich, der dritte reflektierende Bereich und/oder der vierte reflektierende Bereich jeweils als plane Fläche ausgebildet.

Dies ist fertigungstechnisch besonders vorteilhaft.

Gemäss Ausführungsformen der Erfindung weist das Gehäuse eine integrierte Bypass-Diode, insbesondere eine Schottky-Diode, auf. Die Bypass-Diode kann insbesondere in den Basiskörper, der insbesondere aus Kunststoff bestehen kann, integriert werden. Durch eine derartige Integration der Bypass-Diode in jedem einzelnen Modul wird eine besonders hohe Zuverlässigkeit des entsprechenden Photovoltaik-Systems erzielt. Ist ein Konzentrator-Photovoltaik-Modul defekt oder nicht voll funktionsfähig, so kann der Strom über die Bypass-Diode umgeleitet werden und die Funktionsfähigkeit des Gesamtsystems wird nicht bzw. kaum beeinträchtigt.

Gemäss weiteren Ausführungsformen der Erfindung weist das Konzentrator-Photovoltaik-Modul eine Linse als primäre Optik zur Fokussierung des Sonnenlichtes auf. Die Linse ist in einem vordefinierten Abstand von der transparenten Abdeckung angeordnet. Die einen Reflektor bildenden reflektierenden Bereiche der Aufnahmewanne fungieren bei einer solchen Ausführungsform als sekundäre Optik. Mittels einer derartigen zweistufen Anordnung kann die Konzentrationswirkung weiter erhöht werden.

Ein weiterer Aspekt der Erfindung betrifft ein photovoltaisches System, welches eine Vielzahl von Konzentrator-Photovoltaik-Modulen aufweist. Die Konzentrator-Photovoltaik-Module sind dabei insbesondere auf einer Leiterplatte als oberflächenmontierte Bauteile aufgebracht. Die Anzahl der einzelnen Konzentrator-Photovoltaik-Module in einem solchen System kann an die gewünschte Leistung und die jeweils vorgesehene Anwendung angepasst werden. Unter einer Leiterplatte wird hier generell ein Träger für die Konzentrator-Photovoltaik-Module verstanden. Die Leiterplatte kann gemäss Ausführungsformen relativ starr sein. Gemäss anderen Ausführungsformen kann die Leiterplatte aber auch als eine flexible Folie ausgebildet sein. Gemäss Ausführungsformen kann die Leiterplatte insbesondere aus Verbundwerkstoffen bestehen. Gemäss Ausführungsformen kann die Leiterplatte insbesondere Polyester, Poly(p-phenylenterephthalamid), insbesondere Kevlar^{®}, oder Karbon aufweisen oder aus diesen Materialien bestehen.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
FIG. 1a zeigt eine Querschnittsansicht eines Konzentrator-Photovoltaik-Moduls gemäss einer Ausführungsform der Erfindung;
FIG. 1b zeigt eine weitere Querschnittsansicht des Konzentrator-Photovoltaik-Moduls gemäss FIG. 1a;
FIG. 1c zeigt eine korrespondierende Draufsicht auf das Konzentrator-Photovoltaik-Modul gemäss den Figuren 1a und 1b;
FIG. 2a zeigt eine Querschnittsansicht eines Konzentrator-Photovoltaik-Moduls gemäss einer weiteren Ausführungsform der Erfindung;
FIG. 2b zeigt eine weitere Querschnittsansicht des Konzentrator-Photovoltaik-Moduls gemäss FIG. 2a;
FIG. 2c zeigt eine korrespondierende Draufsicht auf das Konzentrator-Photovoltaik-Modul gemäss den Figuren 2a und 2b;
FIG. 3 zeigt eine Querschnittsansicht eines Konzentrator-Photovoltaik-Moduls 300 gemäss einer Ausführungsform der Erfindung inklusive seitlichen elektrischen Anschlüssen;
FIG. 4 zeigt eine Querschnittsansicht eines Konzentrator-Photovoltaik-Moduls gemäss einer weiteren Ausführungsform der Erfindung mit elektrischen Anschlüssen unterhalb des Moduls;
FIG. 5a zeigt eine Querschnittsansicht eines Konzentrator-Photovoltaik-Moduls gemäss einer weiteren Ausführungsform der Erfindung mit einem eingesetzten Reflektor;
FIG. 5b zeigt eine weitere Querschnittsansicht des Konzentrator-Photovoltaik-Moduls gemäss FIG. 5a;
FIG. 5c zeigt eine Draufsicht auf das Konzentrator-Photovoltaik-Modul gemäss den Figuren 5a und 5b;
FIG. 6 zeigt eine Querschnittsansicht eines Konzentrator-Photovoltaik-Moduls gemäss einer weiteren Ausführungsform der Erfindung;
FIG. 7 zeigt eine Querschnittsansicht eines Konzentrator-Photovoltaik-Moduls gemäss einer weiteren Ausführungsform der Erfindung;
FIG. 8 zeigt eine Seitenansicht eines Hauses mit einem schrägen Dach und auf dem Dach und an Seitenwänden angeordneten photovoltaischen Systemen;
FIG. 9 zeigt eine Draufsicht des Hauses gemäss FIG. 8;
FIG. 10 zeigt eine Seitenansicht eines Hauses mit einem flachen Dach und einem auf dem flachen Dach angeordneten photovoltaischem System;
FIG. 11 zeigt eine Draufsicht auf ein photovoltaisches System mit einer Vielzahl von Konzentrator-Photovoltaik-Modulen; und

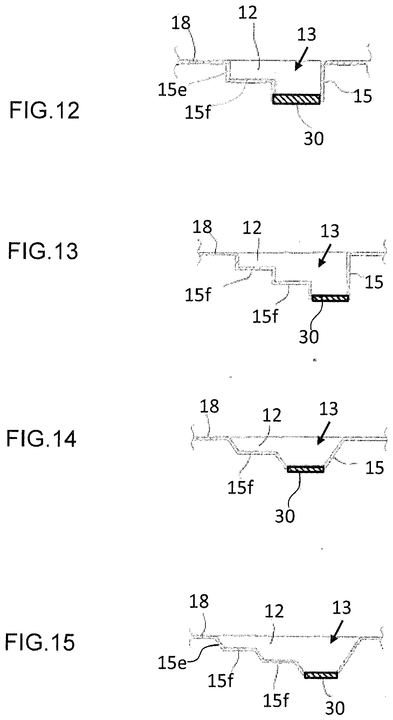

FIG. 12 bis 15 zeigen weitere exemplarische Querschnittsansichten von Konzentrator-Photovoltaik-Modulen gemäss weiteren Ausführungsformen der Erfindung, insbesondere mit gestuften Seitenwänden der Aufnahmewanne.

### Weg(e) zur Ausführung der Erfindung

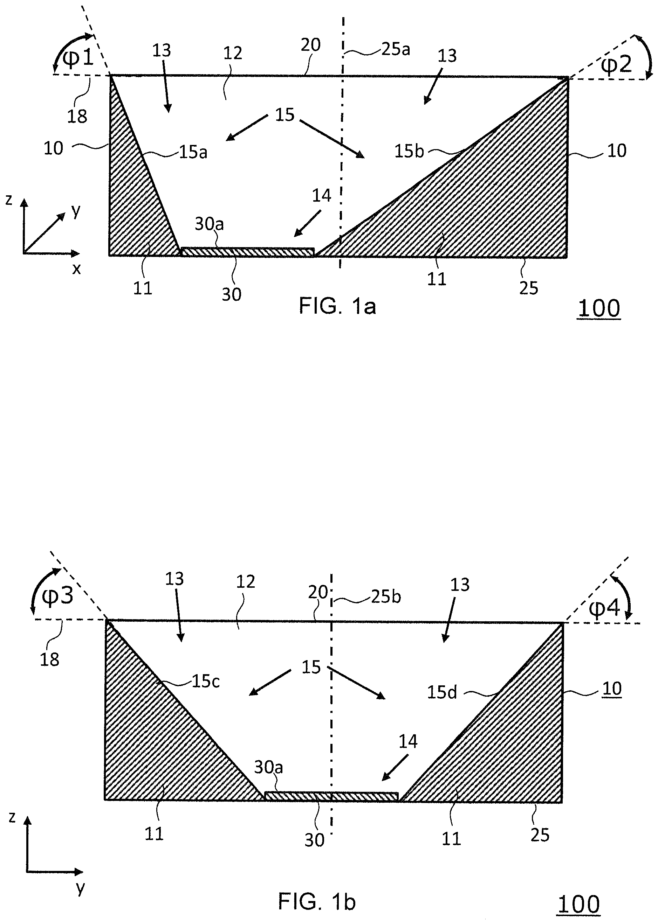

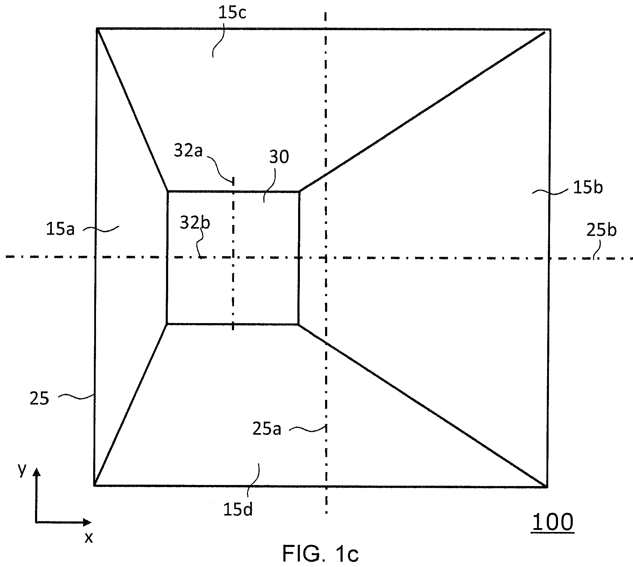

FIG. 1a zeigt eine erste Querschnittsansicht eines Konzentrator-Photovoltaik-Moduls 100 in einer x-z-Ebene gemäss einer Ausführungsform der Erfindung. FIG. 1b zeigt eine weitere Querschnittsansicht des Konzentrator-Photovoltaik-Moduls 100 in einer y-z-Ebene, die senkrecht zu der x-z-Ebene verläuft. FIG. 1c zeigt eine Draufsicht auf das Konzentrator-Photovoltaik-Modul 100 in der x-y-Ebene.

Das Konzentrator-Photovoltaik-Modul 100 weist ein Gehäuse 10 auf, welches einen Basiskörper 11 umfasst. Der Basiskörper 11 besteht aus Kunststoff und kann beispielsweise mittels eines Spritzgussverfahrens hergestellt werden. Das Gehäuse 10 bzw. der Basiskörper 11 weist eine Aussparung 12 auf. Die Aussparung 12 formt bzw. bildet eine Aufnahmewanne 13 mit einem vertieften Bodenabschnitt 14 zur Aufnahme eines Photovoltaik-Chips 30. Der Photovoltaik-Chip 30 ist gemäss bevorzugten Ausgestaltungen der Erfindung als Multi-Junction Solarzelle ausgebildet, kann aber gemäss anderen Ausführungsformen der Erfindung auch als Single-Junction Solarzelle ausgebildet sein. Unter einem Photovoltaik-Chip wird gemäss Ausführungsformen der Erfindung insbesondere ein photovoltaischer DIE, d.h. ein ungehäustes Stück eines Halbleiter-Wafers mit einer Multi-Junction oder Single-Junction Solarzelle verstanden.

Das Konzentrator-Photovoltaik-Modul 100 weist wenigstens zwei elektrische Kontakte zur Kontaktierung des Photovoltaik-Chips 30 auf, welche in den FIG. 1a bis 1d zur Vereinfachung der Illustration nicht dargestellt sind. Das Konzentrator-Photovoltaik-Modul 100 weist ferner eine transparente Abdeckung 20 auf, welche das Gehäuse 10 und insbesondere die Aussparung 12 verschliesst, insbesondere wasserdicht und staubdicht verschliesst. Die transparente Abdeckung 20 besteht gemäss Ausführungsformen aus Glas, insbesondere aus Gorilla-Glas. Vorzugsweise ist das Modul 100 mittels der transparenten Abdeckung 20 gegen feste Fremdkörper und gegen Flüssigkeiten geschützt. Hierzu kann das Modul 100 insbesondere gemäss der IP Schutzklasse 66 ausgebildet sein. Gemäss Ausführungsformen weist das Modul 100 einen Schutzumfang gemäss dem International Protection (IP-Code) gegen feste Fremdkörper von wenigstens 4 und einen Schutzumfang gegen Flüssigkeiten von wenigstens 4 auf. Die transparente Abdeckung 20 kann beispielsweise mittels Ultraschallschweissen an dem Gehäuse 10, insbesondere an dem Basiskörper 11, befestigt werden.

Die Aufnahmewanne 13 weist Seitenwände 15 mit einem ersten reflektierenden Bereich 15a, einem zweiten reflektierendem Bereich 15b, einem dritten reflektierenden Bereich 15c und einem vierten reflektierendem Bereich 15d auf. Der erste reflektierende Bereich 15a ist in einem ersten Winkel ϕ1 gegenüber einer horizontalen x-y-Ebene 18 des Gehäuses 10 ausgerichtet ist. Der zweite reflektierende Bereich 15b ist in einem zweiten Winkel ϕ2 gegenüber der horizontalen x-y-Ebene 18 des Gehäuses 10 ausgerichtet ist. Der dritte reflektierende Bereich 15c ist in einem dritten Winkel ϕ3 gegenüber der horizontalen x-y-Ebene 18 des Gehäuses 10 ausgerichtet ist. Der vierte reflektierende Bereich 15d ist in einem vierten Winkel ϕ4 gegenüber der horizontalen x-y-Ebene 18 des Gehäuses ausgerichtet ist. Gemäss der in den Figuren 1a bis 1d dargestellten Ausführungsform ist der erste Winkel ϕ1 unterschiedlich zu dem zweiten Winkel ϕ2, während der dritte Winkel ϕ3 und der vierte Winkel ϕ4 in diesem Beispiel gleich gross bzw. in etwa gleich gross sind.

Wie insbesondere aus den Figuren 1a und 1b ersichtlich, ist der Photovoltaik-Chip 30 in Bezug auf die vertikale Symmetrieebene 25a des Gehäuses 10 asymmetrisch angeordnet, während er in Bezug auf die vertikale Symmetrieebene 25b des Gehäuses 10 symmetrisch angeordnet ist.

Wie insbesondere aus der Figuren 1a und 1c ersichtlich ist, liegen sich der erste reflektierende Bereich 15a und der zweite reflektierende Bereich 15b in Bezug auf den Photovoltaik-Chip 30 gegenüber, insbesondere in Bezug auf eine in der FIG. 1c gezeigte erste vertikale Symmetrieebene (32a) des Photovoltaik-Chips (30).

Mit anderen Worten liegt der erste reflektierende Bereich 15a auf einer Seite des Photovoltaik-Chips 30 und der zweite reflektierende Bereich 15b auf der gegenüberliegenden Seite des Photovoltaik-Chips 30. Gemäss dem gezeigten Beispiel beträgt der erste Winkel ϕ1 ungefähr 65° und der zweite Winkel ϕ2 ungefähr 35°.

Gemäss Ausführungsformen der Erfindung liegen die Winkel ϕ1, ϕ2, ϕ3 und ϕ4 in einem Bereich zwischen 0° und 90°. Gemäss bevorzugten Ausgestaltungen der Erfindung liegt der erste Winkel ϕ1 in einem Bereich zwischen 45° und 90°, insbesondere in einem Bereich zwischen 60° und 75° und ist somit relativ steil, während der zweite Winkel ϕ2 in einem Bereich zwischen 0° und 45°, insbesondere in einem Bereich zwischen 10° und 35°, liegt, und somit relativ flach ist. Eine derartige Ausgestaltung ist z.B. für Photovoltaik-Module vorteilhaft, welche an vertikalen Hauswänden angebracht werden. Damit wird es ermöglicht, die Leistungsausbeute des Photovoltaik-Moduls bei Anbringung an vertikalen Hauswänden deutlich zu verbessen, indem insbesondere die "untere" reflektierende Fläche stärker in Bezug auf die horizontale Ebene des Gehäuses geneigt ist als die "obere" reflektierende Fläche.

Gemäss Ausführungsformen sind der erste reflektierende Bereich 15a, der zweite reflektierende Bereich 15b, der dritte reflektierende Bereich 15c und der vierte reflektierende Bereich 15d als Beschichtung auf dem Basiskörper 11 der Aufnahmewanne 13 aufgebracht.

Gemäss anderen Ausführungsformen sind der erste reflektierende Bereich 15a, der zweite reflektierende Bereich 15b, der dritte reflektierende Bereich 15c und der vierte reflektierende Bereich 15d als reflektierende Folie ausgebildet, welche z.B. mittels Kleben oder anderen Verfahren auf den Basiskörper 11 der Aufnahmewanne 13 aufgebracht werden kann.

Gemäss den in den Figuren 1a bis 1d gezeigten Ausführungsformen sind die reflektierenden Bereiche 15a, 15b, 15c und 15d jeweils als plane Flächen ausgebildet, insbesondere als trapezförmige Flächen.

Gemäss anderen nicht dargestellten Ausführungsformen können die reflektierenden Bereiche 15a, 15b, 15c und 15d jedoch auch andere Formen aufweisen, insbesondere konkave Formen und konvexe Formen.

Die Aufnahmewanne 13 mit den reflektierenden Bereichen 15a, 15b, 15c und 15d ist als Reflektor für ein Konzentrator-Photovoltaik-System konfiguriert. Das einfallende Sonnenlicht wird von der transparenten Abdeckung 20 durchgeleitet und mittels der reflektierenden Bereiche 15a, 15b, 15c und 15d auf die Oberfläche 30a des Photovoltaik-Chips 30 konzentriert.

Ein derart ausgestaltetes Modul ermöglicht es, die Winkel ϕ1, ϕ2, ϕ3 und ϕ4 der reflektierenden Bereiche 15a 15b, 15c and 15d jeweils individuell und unterschiedlich zu wählen und an den vorgesehenen Standort, die jeweilige Ausrichtung der Module an den zum Einbau vorgesehenen Flächen und die damit korrespondierende Sonnenexposition der Module sowohl im Hinblick auf den azimutalen Verlauf als auch im Hinblick auf die Elevation zu berücksichtigen.

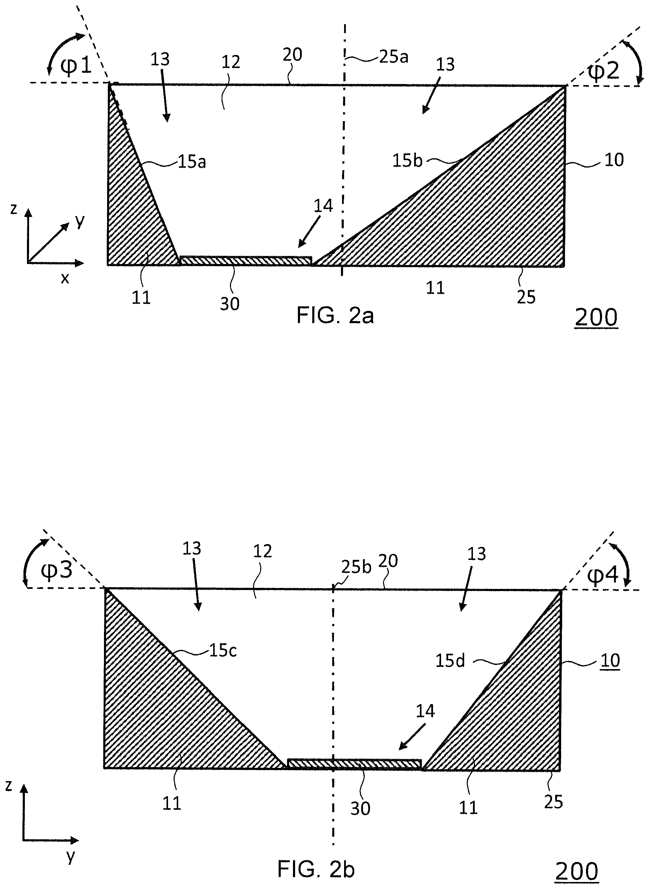

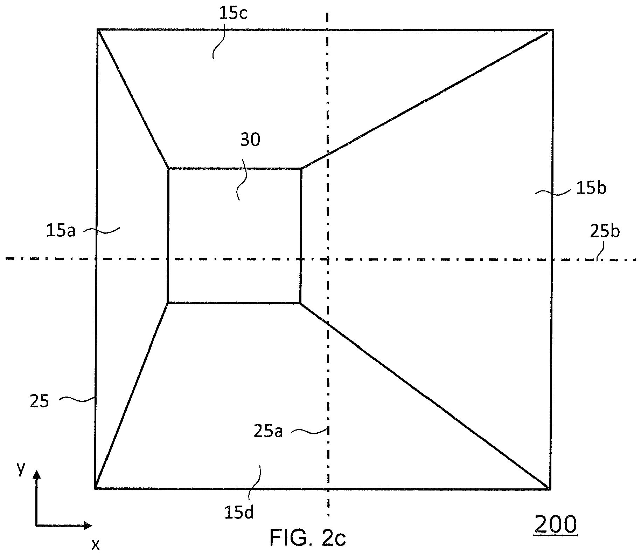

FIG. 2a zeigt eine erste Querschnittsansicht eines Konzentrator-Photovoltaik-Moduls 200 in einer x-z-Ebene gemäss einer Ausführungsform der Erfindung. FIG. 2b zeigt eine weitere Querschnittsansicht des Konzentrator-Photovoltaik-Moduls 200 in einer y-z-Ebene, die senkrecht zu der x-z-Ebene verläuft. FIG. 2c zeigt eine Draufsicht auf das Konzentrator-Photovoltaik-Modul 200 in der x-y-Ebene.Im Gegensatz zu dem Konzentrator-Photovoltaik-Modul 100 sind bei dem Konzentrator-Photovoltaik-Modul 200 nicht nur der erste Winke ϕ1 und der zweite ϕ2 unterschiedlich gross, sondern auch der dritte Winkel ϕ3 und der vierte Winkel ϕ4. Gemäss Ausführungsformen unterscheiden sich der dritte Winkel ϕ3 und der vierte Winkel ϕ4 um wenigstens 10°.

Der dritte Winkel ϕ3 liegt bevorzugt in einem Bereich zwischen 0° und 45°, insbesondere in einem Bereich zwischen 10° und 35°, während der vierte Winkel ϕ4 bevorzugt in einem Bereich zwischen 30° und 90° liegt, insbesondere in einem Bereich zwischen 45° und 75°.

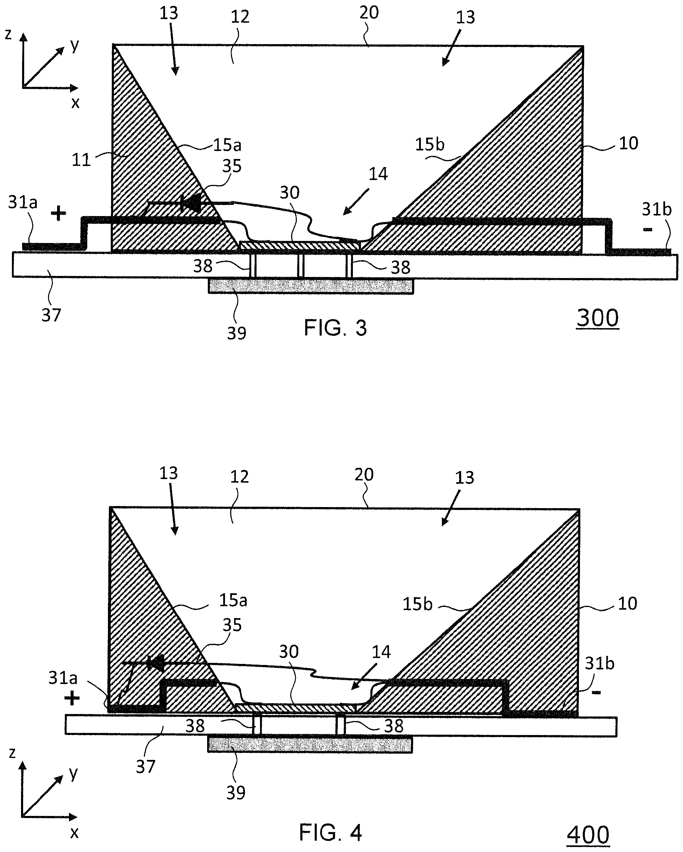

FIG. 3 zeigt eine Querschnittsansicht eines Konzentrator-Photovoltaik-Moduls 300 in einer x-z-Ebene gemäss einer Ausführungsform der Erfindung. In der FIG. 3 sind die elektrischen Anschlüsse des Moduls näher dargestellt. Insbesondere weist das Konzentrator-Photovoltaik-Modul 300 einen ersten elektrischen Kontakt 31a und einen zweiten elektrischen Kontakt 32a auf. Die elektrischen Kontakte 31a, 32a sind auf gegenüberliegenden Seiten des Gehäuses 10 angeordnet und als sogenannte Leads ausgebildet, welche in dem Basiskörper 11 aus Kunststoff eingebettet sind. Der Photovoltaik-Chip 30 ist mittels Wire-Bonding mit den Leads der elektrischen Kontakten 31a und 32a elektrisch verbunden. Somit ist das Modul 300 als oberflächenmontierbares Modul in SMD-Technik (Surface Mount Technology) ausgebildet. Das Modul 300 weist zudem eine in das Gehäuse 10 integrierte Bypass-Diode 35 auf, welche insbesondere als Schottky-Diode ausgeführt sein kann. Die Bypass-Diode ist parallel zu dem Photovoltaik-Chip 30 geschaltet und dementsprechend einerseits mit dem elektrischen Kontakt 31a und andererseits mit dem elektrischen Kontakt 31b verbunden, ebenfalls gemäss Ausführungsformen mittels Wire-Bonding. Der Photovoltaik-Chip 30 kann beispielsweise mit Leiterbahnen einer Leiterplatte 37 mittels Löten elektrisch kontaktiert werden. Unterhalb *des* Photovoltaik-Chips 30 weist die Leiterplatte 37 thermische Durchführungen/Vias 38 auf, welche zur Wärmeabführung der von dem Photovoltaik-Chip 30 produzierten Wärme an ein thermisches Pad 39 vorgesehen sind.

FIG. 4 zeigt eine Querschnittsansicht eines Konzentrator-Photovoltaik-Moduls 400 in einer x-z-Ebene gemäss einer weiteren Ausführungsform der Erfindung. In der FIG. 4 sind ebenfalls die elektrischen Anschlüsse des Moduls näher dargestellt. Gemäss der Ausführungsform von FIG. 4 weist das Konzentrator-Photovoltaik-Modul 400 zwei elektrische Kontakte 31a, 31b auf, welche unter dem Gehäuse 10 angeordnet sind.

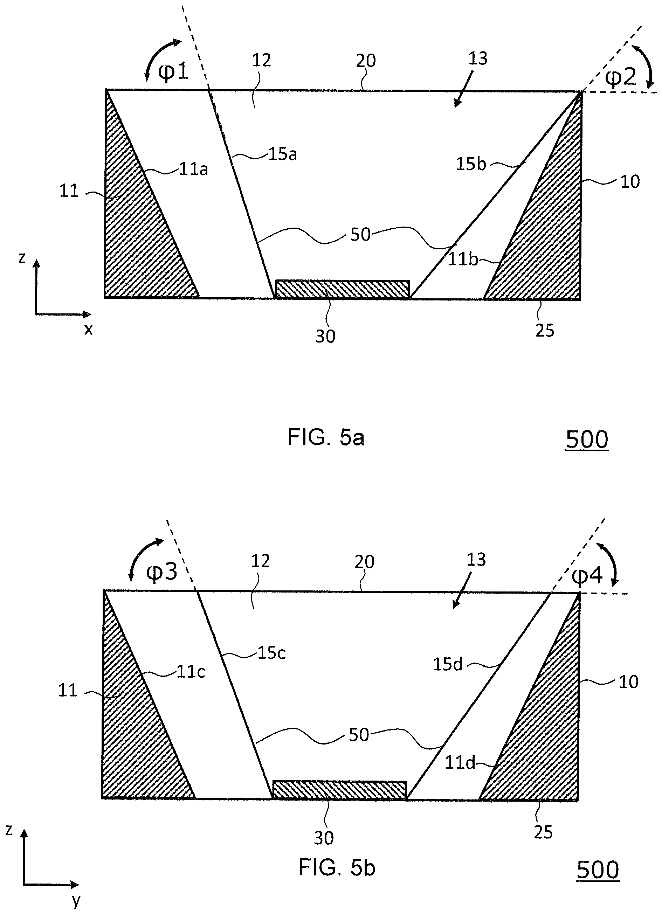

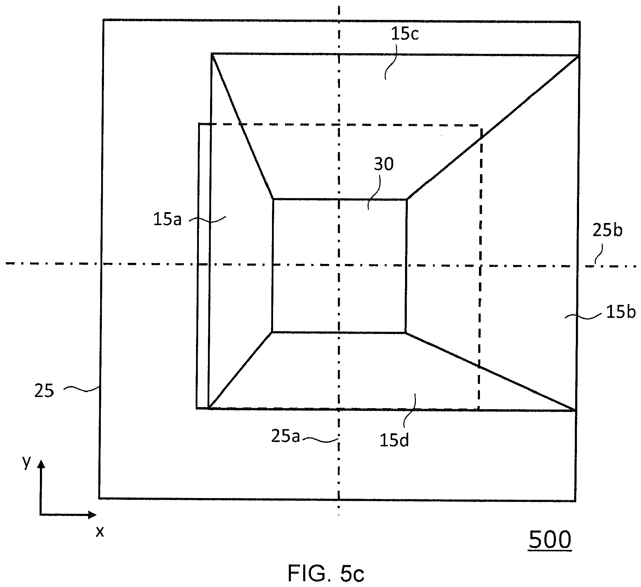

FIG. 5a zeigt eine erste Querschnittsansicht eines Konzentrator-Photovoltaik-Moduls 500 in einer x-z-Ebene gemäss einer weiteren Ausführungsform der Erfindung. FIG. 5b zeigt eine weitere Querschnittsansicht des Konzentrator-Photovoltaik-Moduls 500 in einer y-z-Ebene, die senkrecht zu der x-z-Ebene verläuft. FIG. 5c zeigt eine Draufsicht auf das Konzentrator-Photovoltaik-Modul 500 in der x-y- Ebene.

Gemäss dieser Ausführungsform sind die reflektierenden Seitenwände mit den reflektierenden Bereichen nicht direkt auf dem Basiskörper 11 des Gehäuses 10 aufgebracht, sondern sie sind als separater Einsatz 50 ausgebildet, welcher in die Aufnahmewanne 13 eingesetzt ist. Der separate Einsatz 50 kann beispielsweise mittels Ultraschallschweissens an dem Gehäuse 10 befestigt werden. Gemäss anderen Ausführungsformen kann der separate Einsatz 50 mittels eines Klicksystems an vordefinierten Befestigungspunkten des Gehäuses 10 befestigt werden. Gemäss anderen Ausführungsformen kann der separate Einsatz 50 an dem Gehäuse 10 mittels Kleben oder einer anderen geeigneten Befestigungstechnik angebracht werden. Der separate Einsatz 50 kann insbesondere als Metalleinsatz oder als Kunststoffeinsatz ausgebildet sein. Die unterschiedlichen Winkel ϕ1, ϕ2, ϕ3 und ϕ4 der reflektierenden Bereiche werden gemäss dieser Ausführungsform mittels des separaten Einsatzes 50 realisiert, während die Seitenwände 11a, 11b , 11c und 11d des Basiskörpers 11 denselben Winkel aufweisen können. Dies erlaubt es, den Basiskörper 11 mit grossen Stückzahlen zu fertigen und die individuale Anpassung der Winkel mittels des separaten Einsatzes 50 vorzunehmen.

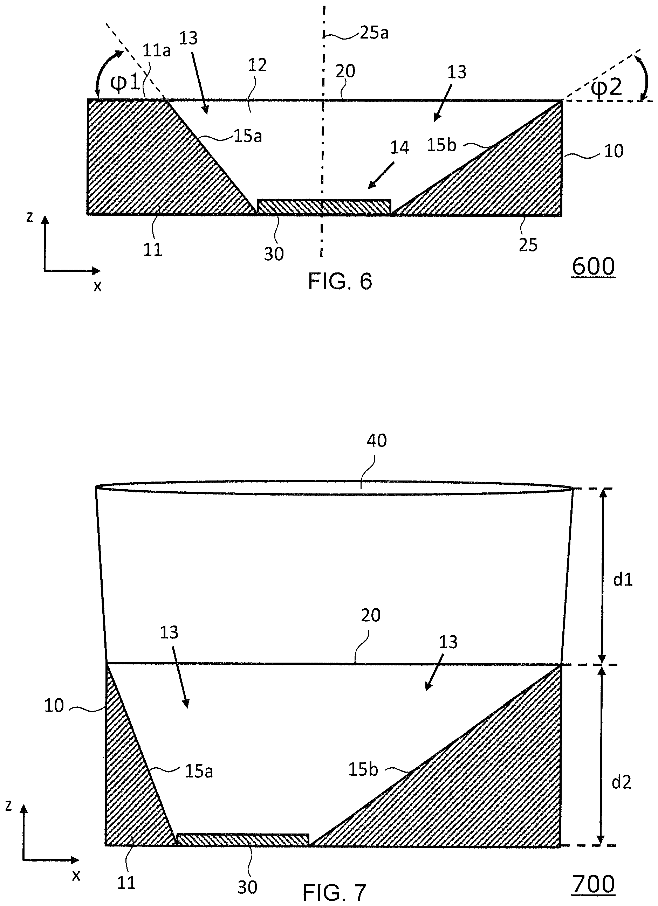

FIG. 6 zeigt eine Querschnittsansicht eines Konzentrator-Photovoltaik-Moduls 600 in einer x-z-Ebene gemäss einer weiteren Ausführungsform der Erfindung. Gemäss dieser Ausführungsform ist der Photovoltaik-Chip symmetrisch in Bezug auf die vertikale Symmetrieebene 25a des Gehäuses 10 angeordnet. Um dennoch unterschiedliche Winkel ϕ1 und ϕ2 zu realisieren, weist der Basiskörper 11 auf der linken Seite eine relativ breite Oberseite 11a auf.

FIG. 7 zeigt eine Querschnittsansicht eines Konzentrator-Photovoltaik-Moduls 700 in einer x-z-Ebene gemäss einer weiteren Ausführungsform der Erfindung.

Das Konzentrator-Photovoltaik-Modul weist neben der als Sekundäroptik fungierenden reflektierenden Aufnahmewanne 13 eine Linse 40 als primäre Optik zur Fokussierung des Sonnenlichtes auf. Die Linse 40 ist in einem vordefinierten Abstand d1 von der Glasabdeckung 20 des Gehäuses 10 befestigt. Die Höhe des Gehäuses 10 ist mit d2 bezeichnet. Gemäss Ausführungsformen der Erfindung liegt die Höhe d2 des Gehäuses 10 zwischen 3 mm und 6 mm.

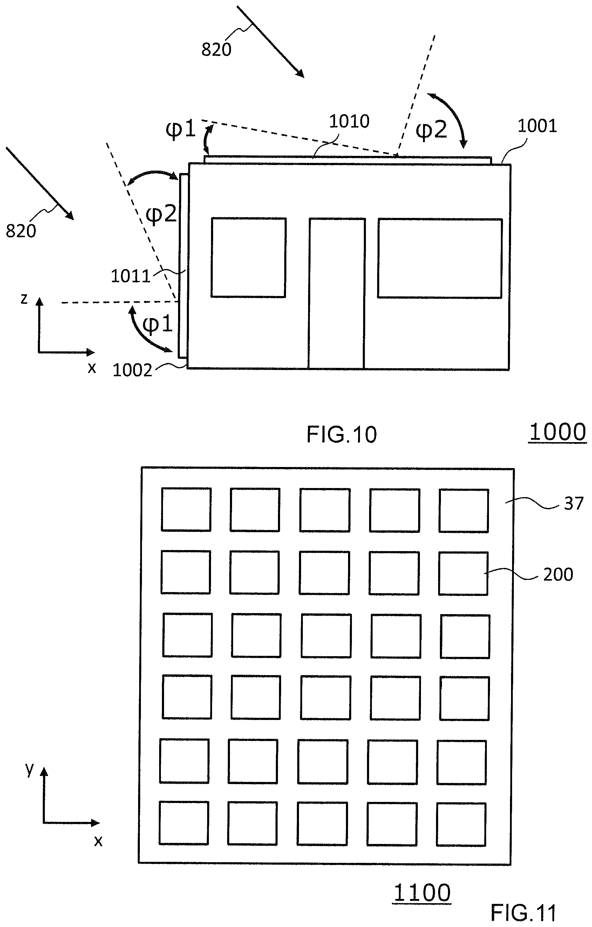

FIG. 11 zeigt eine Draufsicht auf ein photovoltaisches System 1100 gemäss einer Ausführungsform der Erfindung. Das photovoltaische System 1100 weist eine Vielzahl der oben beschriebenen Konzentrator-Photovoltaik-Module auf, z.B. eine Vielzahl der Photovoltaik-Module 200. Die Konzentrator-Photovoltaik-Module 200 sind auf einer Leiterplatte 37 als oberflächenmontierte Bauteile aufgebracht. Die Leiterplatte 37 kann insbesondere als flexible Folie ausgebildet sein.

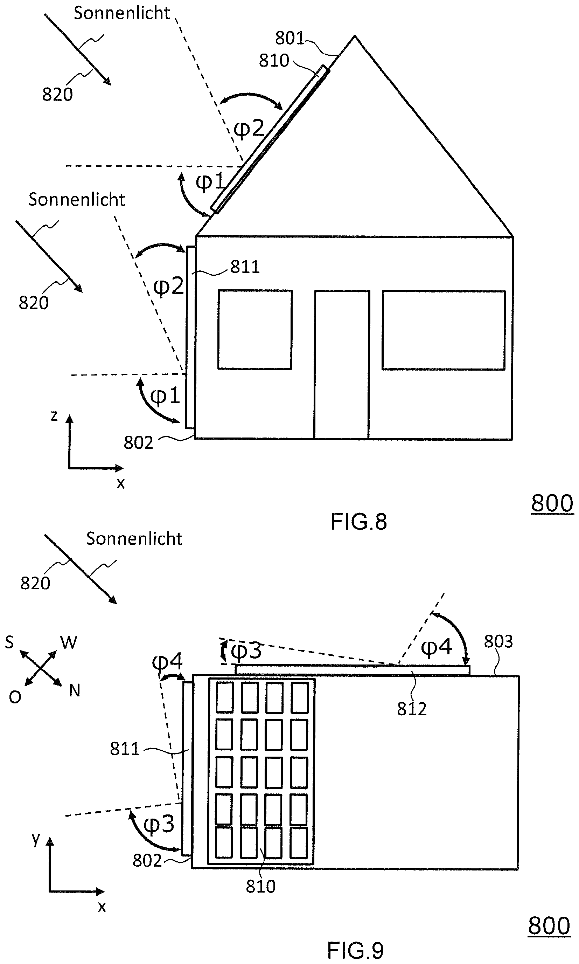

FIG. 8 zeigt eine Seitenansicht eines Hauses 800. Das Haus 800 weist auf einem schrägen Dach 801 ein photovoltaisches System 810 und auf einer senkrechten Seitenwand 802 ein photovoltaisches System 811 auf.

FIG. 9 zeigt eine Draufsicht des Hauses 800. Hier ist zu erkennen, dass das Haus 800 zusätzlich zu dem photovoltaischen System 810 und dem photovoltaischen System 811 ein weiteres photovoltaisches System 812 auf der Rückwand 803 aufweist.

Die photovoltaischen Systeme 810, 811 und 812 weisen eine Vielzahl der oben beschriebenen Konzentrator-Photovoltaik-Module auf und können insbesondere wie in der Draufsicht der FIG. 11 dargestellt ausgebildet sein.

In den Figuren 8 und 9 ist der Sonnenstand 820 in exemplarischer Weise dargestellt, z.B. zu der Mittagszeit.

Zudem sind in der Figur 8 der erste Winkel ϕ1 und der zweite Winkel ϕ2 der einzelnen Konzentrator-Photovoltaik-Module der Systeme 810 und 811 in exemplarischer Weise mittels gestrichelter Linien dargestellt.

Darüber hinaus sind in der Figur 9 der dritte Winkel ϕ3 und der vierte Winkel ϕ4 der einzelnen Konzentrator-Photovoltaik-Module der Systeme 810 und 812 in exemplarischer Weise mittels gestrichelter Linien dargestellt.

In dem Beispiel der Figuren 8 und 9 weisen die einzelnen Konzentrator-Photovoltaik-Module der Systeme 810, 811 und 812 jeweils unterschiedliche Kombinationen der einzelnen Winkel ϕ1, ϕ2, ϕ3 und ϕ4 auf. Dadurch ist es möglich, die jeweilige Einbausituation der Systeme 810, 811 und 812 zu berücksichtigen und die Winkel ϕ1, ϕ2, ϕ3 und ϕ4 optimal an den Sonnenstand bzw. Sonnenverlauf anzupassen, um eine maximale Konzentrationswirkung bzw. Verstärkung des Reflektors zu erzielen.

Der erste Winkel ϕ1 und der zweite Winkel ϕ2 sind gemäss Ausführungsformen der Erfindung insbesondere so gewählt, dass sie die jeweilige Einbausituation optimal in Bezug auf die Elevation der Sonne berücksichtigen.

Der dritte Winkel ϕ3 und der vierte Winkel ϕ4 sind gemäss Ausführungsformen der Erfindung insbesondere so gewählt, dass sie die jeweilige Einbausituation optimal in Bezug auf den Azimut der Sonne berücksichtigen. So ist in der FIG. 9 auch die Ausrichtung des Hauses in Bezug auf die Himmelsrichtungen dargestellt. Die Hauswand 802 weist beispielhaft eine Südost-Exposition auf und die Rückwand 803 eine Südwest-Exposition. Durch geeignete und individuelle Wahl der Winkel ϕ3 und ϕ4 für die Seitenwand 802 und die Rückwand 803 kann der Wirkungsgrad des Konzentrator-Photovoltaik Moduls verbessert werden.

FIG. 10 zeigt eine Seitenansicht eines Hauses 1000 mit einem flachen Dach 1001. Auf dem flachen Dach 1001 ist ein photovoltaisches System 1010 und auf einer senkrechten Seitenwand 1002 ein photovoltaisches System 1011 angebracht.

Der erste Winkel ϕ1 und der zweite Winkel ϕ2 des photovoltaischen System 1010 sind anders gewählt als der erste Winkel ϕ1 und der zweite Winkel ϕ2 des photovoltaischen Systems 810 des in der FIG. 8 dargestellten Schrägdachs, um die Reflektorwirkung der Konzentrator-Photovoltaik Module zu verbessern.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

## Patentansprüche

1. Konzentrator-Photovoltaik-Modul, aufweisend
ein Gehäuse (10);
einen Photovoltaik-Chip (30);
wenigstens zwei elektrische Kontakte (31a, 31b) zur Kontaktierung des Photovoltaik-Chips (30);
eine transparente Abdeckung (20);
wobei
das Gehäuse (10) eine Aufnahmewanne zur Aufnahme des Photovoltaik-Chips (30) aufweist;
die Aufnahmewanne (13) Seitenwände (15) mit wenigstens einem ersten und einem zweiten reflektierenden Bereich (15a, 15b) aufweist, wobei der erste reflektierende Bereich (15a) in einem ersten Winkel (ϕ1) gegenüber einer horizontalen Ebene (18) des Gehäuses (10) ausgerichtet ist und der zweite reflektierende Bereich (15b) in einem zweiten Winkel (ϕ2) gegenüber der horizontalen Ebene (18) des Gehäuses (10) ausgerichtet ist; und
der erste Winkel (ϕ1) unterschiedlich zu dem zweiten Winkel (ϕ2) ist, **dadurch gekennzeichnet, dass**
das Gehäuse einen Basiskörper (11) aus Kunststoff aufweist;
der Basiskörper (11) aus Kunststoff eine die Aufnahmewanne (13) bildende Aussparung (12) mit einem vertieften Bodenabschnitt (14) zur Aufnahme des Photovoltaik-Chips (30) aufweist; und
das Konzentrator-Photovoltaik-Modul als oberflächenmontierbares Modul in SMD-Technik ausgebildet ist.

2. Konzentrator-Photovoltaik-Modul nach Anspruch 1, wobei der Photovoltaik-Chip (30) in Bezug auf wenigstens eine vertikale Symmetrieebene (25a) des Gehäuses (10) asymmetrisch angeordnet ist.

3. Konzentrator-Photovoltaik-Modul nach Anspruch 1 oder 2, wobei sich der erste und der zweite reflektierende Bereich (15a, 15b) in Bezug auf eine erste vertikale Symmetrieebene (32a) des Photovoltaik-Chips (30) gegenüberliegen.

4. Konzentrator-Photovoltaik-Modul nach einem der vorhergehenden Ansprüche, wobei sich der erste Winkel (ϕ1) und der zweite Winkel (ϕ2) um wenigstens 10°, insbesondere um wenigstens 20° unterscheiden.

5. Konzentrator-Photovoltaik-Modul nach einem der vorhergehenden Ansprüche, wobei die wenigstens zwei elektrischen Kontakte (31a, 31b) an wenigstens zwei Seiten des Gehäuses (10) angeordnet sind.

6. Konzentrator-Photovoltaik-Modul nach einem der vorhergehenden Ansprüche, wobei die wenigstens zwei elektrischen Kontakte (31a, 31b) unter dem Gehäuse (10)angeordnet sind.

7. Konzentrator-Photovoltaik-Modul nach einem der vorhergehenden Ansprüche, wobei
der erste Winkel (ϕ1) in einem Bereich zwischen 0° und 90° liegt, insbesondere in einem Bereich zwischen 45° und 90°, insbesondere in einem Bereich zwischen 60° und 75°; und
der zweite Winkel (ϕ2) in einem Bereich zwischen 0° und 90° liegt, insbesondere in einem Bereich zwischen 0° und 45°, insbesondere in einem Bereich zwischen 10° und 35°.

8. Konzentrator-Photovoltaik-Modul nach einem der vorhergehenden Ansprüche, wobei die Aufnahmewanne (13) Seitenwände (15) mit einem dritten und einem vierten reflektierenden Bereich (15c, 15d)aufweist, wobei der dritte reflektierende Bereich (15c) in einem dritten Winkel (ϕ3) gegenüber der horizontalen Ebene des Gehäuses (10) ausgerichtet ist und der vierte reflektierende Bereich (15d) in einem vierten Winkel (ϕ4) gegenüber der horizontalen Ebene des Gehäuses (10) ausgerichtet ist, wobei insbesondere der dritte Winkel unterschiedlich zu dem vierten Winkel ist.

9. Konzentrator-Photovoltaik-Modul nach Anspruch 8, wobei sich der dritte Winkel (ϕ3) und der vierte Winkel (ϕ4) um wenigstens 10°, insbesondere um wenigstens 20° unterscheiden.

10. Konzentrator-Photovoltaik-Modul nach Anspruch 8 oder 9, wobei sich der erste und der zweite reflektierende Bereich (15a, 15b) in Bezug auf eine erste vertikale Symmetrieebene (30a) des Photovoltaik-Chips (30) gegenüberliegen und wobei sich der dritte und der vierte reflektierende Bereich (15c, 15d) in Bezug auf eine zweite vertikale Symmetrieebene (30b) des Photovoltaik-Chips gegenüberliegen, und wobei insbesondere die erste vertikale Symmetrieebene und die zweite vertikale Symmetrieebene senkrecht zueinander verlaufen.

11. Konzentrator-Photovoltaik-Modul nach einem der Ansprüche 8 bis 10, wobei
der dritte Winkel (ϕ3) in einem Bereich zwischen 0° und 45° liegt, insbesondere in einem Bereich zwischen 10° und 35°; und
der vierte Winkel (ϕ4) in einem Bereich zwischen 30° und 90° liegt, insbesondere in einem Bereich zwischen 45° und 75°.

12. Konzentrator-Photovoltaik-Modul nach einem der vorhergehenden Ansprüche, wobei die Aufnahmewanne (13)als sekundärer Reflektor für ein Konzentrator-Photovoltaik-System (700) konfiguriert ist.

13. Konzentrator-Photovoltaik-Modul nach einem der vorhergehenden Ansprüche, wobei der Photovoltaik-Chip (30) eine Mehrfachsolarzelle, insbesondere eine Mehrfachsolarzelle aus einem III-V Halbleitermaterial ist.

14. Konzentrator-Photovoltaik-Modul nach einem der vorhergehenden Ansprüche, aufweisend
eine Linse (40) als primäre Optik zur Fokussierung des Sonnenlichtes, wobei die Linse in einem vordefinierten Abstand (d1) von der transparenten Abdeckung (20) angeordnet ist.

15. Photovoltaisches System, aufweisend
eine Vielzahl von Konzentrator-Photovoltaik-Modulen nach einem der vorhergehenden Ansprüche;
wobei die Konzentrator-Photovoltaik-Module auf einer Leiterplatte (37) als oberflächenmontierte Bauteile aufgebracht sind.

## Claims

1. Concentrator photovoltaic module, comprising
a housing (10);
a photovoltaic chip (30);
at least two electrical contacts (31a, 31b) for contacting the photovoltaic chip (30);
a transparent cover (20);
wherein
the housing (10) has a receiving tray (13) for receiving the photovoltaic chip (30);
the receiving tray (13) has side walls (15) with at least a first and a second reflective region (15a, 15b), the first reflective region (15a) being oriented at a first angle (ϕ1) with respect to a horizontal plane (18) of the housing (10) and the second reflective region (15b) being oriented at a second angle (ϕ2) with respect to the horizontal plane (18) of the housing (10); and
the first angle (ϕ1) is different from the second angle (ϕ2); **characterized in that**
the housing (10) comprises a base body (11) made of plastic;
the base body made of plastic has a recess (12) forming the receiving tray (13) with a recessed bottom portion (14) for receiving the photovoltaic chip (30); and
the concentrator photovoltaic module is formed as a surface mountable module in SMD-technique.

2. Concentrator photovoltaic module according to claim 1, wherein the photovoltaic chip (30) is arranged asymmetrically with respect to at least one vertical symmetry plane (25a) of the housing (10).

3. Concentrator photovoltaic module according to claim 1 or 2, wherein the first and the second reflective regions (15a, 15b) are opposite to each other with respect to a first vertical symmetry plane (32a) of the photovoltaic chip (30).

4. Concentrator photovoltaic module according to any one of the preceding claims, wherein the first angle (ϕ1) and the second angle (ϕ2) differ by at least 10°, in particular by at least 20°.

5. Concentrator photovoltaic module according to any of the preceding claims, wherein the at least two electrical contacts (31a, 31b) are arranged on at least two sides of the housing (10).

6. Concentrator photovoltaic module according to any of the preceding claims, wherein the at least two electrical contacts (31a, 31b) are arranged under the housing (10).

7. Concentrator photovoltaic module according to any one of the preceding claims, wherein
the first angle (ϕ1) is in a range between 0° and 90°, in particular in a range between 45° and 90°, in particular in a range between 60° and 75°; and
the second angle (ϕ2) is in a range between 0° and 90°, in particular in a range between 0° and 45°, in particular in a range between 10° and 35°.

8. Concentrator photovoltaic module according to any one of the preceding claims, wherein the receiving tray (13) comprises side walls (15) having a third and a fourth reflective region (15c, 15d), wherein the third reflective region (15c) is oriented at a third angle (ϕ3) with respect to the horizontal plane of the housing (10) and the fourth reflective region (15d) is oriented at a fourth angle (ϕ4) with respect to the horizontal plane of the housing (10), wherein in particular the third angle is different from the fourth angle.

9. Concentrator photovoltaic module according to claim 8, wherein the third angle (ϕ3) and the fourth angle (ϕ4) differ by at least 10°, in particular by at least 20°.

10. Concentrator photovoltaic module according to claim 8 or 9, wherein the first and the second reflective region (15a, 15b) are opposite to each other with respect to a first vertical symmetry plane (30a) of the photovoltaic chip (30), and wherein the third and the fourth reflective regions (15c, 15d) are opposite to each other with respect to a second vertical symmetry plane (30b) of the photovoltaic chip, and wherein in particular the first vertical symmetry plane and the second vertical symmetry plane are perpendicular to each other.

11. Concentrator photovoltaic module according to any one of claims 8 to 10, wherein
the third angle (ϕ3) is in a range between 0° and 45°, in particular in a range between 10° and 35°; and
the fourth angle (ϕ4) is in a range between 30° and 90°, in particular in a range between 45° and 75°.

12. Concentrator photovoltaic module according to any one of the preceding claims, wherein the receiving tray (13) is configured as a secondary reflector for a concentrator photovoltaic system (700).

13. Concentrator photovoltaic module according to any one of the preceding claims, wherein the photovoltaic chip (30) is a multi-junction solar cell, in particular a multi-junction solar cell made of a III-V semiconductor material.

14. Concentrator photovoltaic module according to any one of the preceding claims, comprising
a lens (40) as primary optics for focusing the sunlight, the lens being arranged at a predefined distance (d1) from the transparent cover (20).

15. Photovoltaic system comprising
a plurality of concentrator photovoltaic modules according to any one of the preceding claims;
wherein the concentrator photovoltaic modules are mounted on a printed circuit board (37) as surface mounted components.

## Revendications

1. Module photovoltaïque concentrateur, comprenant
un boîtier (10) ;
une puce photovoltaïque (30) ;
au moins deux contacts électriques (31a, 31b) pour entrer en contact avec la puce photovoltaïque (30) ;
un couvercle transparent (20) ;
dans lequel
le boîtier (10) comporte un plateau de réception (13) destiné à recevoir la puce photovoltaïque (30);
le plateau de réception (13) comporte des parois latérales (15) avec au moins une première et une deuxième zone réfléchissante (15a, 15b), la première zone réfléchissante (15a) étant orientée selon un premier angle (ϕ1) par rapport à un plan horizontal (18) du boîtier (10) et la deuxième zone réfléchissante (15b) étant orientée selon un deuxième angle (ϕ2) par rapport au plan horizontal (18) du boîtier (10) ; et
le premier angle (ϕ1) est différent du deuxième angle (ϕ2) ; **caractérisé en ce que**
le boîtier (10) comprend un corps de base (11) en plastique ;
le corps de base en plastique comporte une cavité (12) formant le plateau de réception (13) avec une partie inférieure en retrait (14) pour la réception de la puce photovoltaïque (30) ; et
le module photovoltaïque concentrateur est constitué d'un module montable en surface selon la technique SMD.

2. Module photovoltaïque concentrateur selon la revendication 1, dans lequel la puce photovoltaïque (30) est disposée de manière asymétrique par rapport à au moins un plan de symétrie vertical (25a) du boîtier (10).

3. Module photovoltaïque concentrateur selon la revendication 1 ou 2, dans lequel la première et la deuxième zone réfléchissante (15a, 15b) sont opposées l'une à l'autre par rapport à un premier plan de symétrie vertical (32a) de la puce photovoltaïque (30).

4. Module photovoltaïque concentrateur selon l'une des revendications précédentes, dans lequel le premier angle (ϕ1) et le deuxième angle (ϕ2) diffèrent d'au moins 10°, en particulier d'au moins 20°.

5. Module photovoltaïque concentrateur selon l'une des revendications précédentes, dans lequel les au moins deux contacts électriques (31a, 31b) sont disposés sur au moins deux côtés du boîtier (10).

6. Module photovoltaïque concentrateur selon l'une des revendications précédentes, dans lequel les au moins deux contacts électriques (31a, 31b) sont disposés sous le boîtier (10).

7. Module photovoltaïque concentrateur selon l'une des revendications précédentes, dans lequel le premier angle (ϕ1) est compris entre 0° et 90°, en particulier entre 45° et 90°, en particulier entre 60° et 75° ; et
le deuxième angle (ϕ2) est compris entre 0° et 90°, en particulier entre 0° et 45°, en particulier entre 10° et 35°.

8. Module photovoltaïque concentrateur selon l'une des revendications précédentes, dans lequel le plateau de réception (13) comprend des parois latérales (15) ayant une troisième et une quatrième zone réfléchissante (15c, 15d), dans lequel la troisième région réfléchissante (15c) est orientée à un troisième angle (ϕ3) par rapport au plan horizontal du boîtier (10) et la quatrième région réfléchissante (15d) est orientée à un quatrième angle (ϕ4) par rapport au plan horizontal du boîtier (10), dans lequel en particulier le troisième angle est différent du quatrième angle.

9. Module photovoltaïque concentrateur selon la revendication 8, dans lequel le troisième angle (ϕ3) et le quatrième angle (ϕ4) diffèrent d'au moins 10°, en particulier d'au moins 20°.

10. Module photovoltaïque concentrateur selon la revendication 8 ou 9, dans lequel la première et la deuxième région réfléchissante (15a, 15b) sont opposées l'une à l'autre par rapport à un premier plan de symétrie vertical (30a) de la puce photovoltaïque (30), et dans lequel la troisième et la quatrième région réfléchissante (15c, 15d) sont opposées l'une à l'autre par rapport à un deuxième plan de symétrie vertical (30b) de la puce photovoltaïque, et dans lequel, en particulier, le premier plan de symétrie vertical et le deuxième plan de symétrie vertical sont perpendiculaires l'un à l'autre.

11. Module photovoltaïque concentrateur selon l'une des revendications 8 à 10, dans lequel
le troisième angle (ϕ3) est compris entre 0° et 45°, en particulier entre 10° et 35° ; et
le quatrième angle (ϕ4) est compris entre 30° et 90°, en particulier entre 45° et 75°.

12. Module photovoltaïque concentrateur selon l'une des revendications précédentes, dans lequel le plateau de réception (13) est configuré comme un réflecteur secondaire pour un système photovoltaïque concentrateur (700) .

13. Module photovoltaïque concentrateur selon l'une des revendications précédentes, dans lequel la puce photovoltaïque (30) est une cellule solaire multi-jonction, en particulier une cellule solaire multi-jonction constituée d'un matériau semi-conducteur III-V.

14. Module photovoltaïque concentrateur selon l'une des revendications précédentes, comprenant
une lentille (40) comme optique primaire pour focaliser la lumière solaire, la lentille étant disposée à une distance prédéfinie (d1) du couvercle transparent (20) .

15. Système photovoltaïque comprenant une pluralité de modules photovoltaïques concentrateurs selon l'une des revendications précédentes ;
dans lequel les modules photovoltaïques concentrateurs sont montés sur une carte de circuit imprimé (37) en tant que modules de surface.
